# EUROPEAN PATENT APPLICATION

(11) **EP 4 749 769 A2**
(43) Date of publication of application: **27.05.2026**
(21) Application number: 25211522.5
(22) Date of filing: 27.10.2025
(51) Int. Cl.: H01M 10/613, H01M 10/6556, H01M 10/6567, H01M 10/6569, H01M 50/204

(54) **IMMERSION COOLING MODULE, AND COOLING METHOD**

(30) Priority: 15.11.2024 KR 20240163199
(71) Applicant: SK Innovation Co., Ltd., Seoul 03188 (KR); SK On Co., Ltd., Seoul 03161 (KR)
(72) Inventor: JUNG, In Sik, 34124 Daejeon (KR); MIN, Gi Hong, 34124 Daejeon (KR)
(74) Representative: Prüfer & Partner mbB Patentanwälte · Rechtsanwälte

(57) **Abstract**

Disclosed are an immersion cooling module and a cooling method. The immersion cooling module includes: a housing containing a cooling fluid at a predetermined level, at least one unit housing accommodated inside the housing so as to be impregnated with the cooling fluid, having a flow passage through which the cooling fluid flows in and out and an open top, and accommodating a battery module, and a condenser coupled to liquefy a gas formed by vaporization of the cooling fluid in the housing and reintroduce the liquefied gas into the housing in a liquid state, wherein opposite sides of the battery module may be spaced apart from respective facing inner sides of the unit housing by a predetermined distance to form a flow path for the cooling fluid, and a porous moisture absorption member attached to each of the opposite sides of the battery module may be further included.

## Description

### Technical Field

The present disclosure relates to an immersion cooling module and further to a cooling method of one or more battery modules in an immersion cooling module.

### Description of the Related Art

In recent years, mobile devices such as mobile phones and laptops have become smaller and lighter, and electric vehicles and hybrid vehicles demand high-capacity power sources, which has driven the development and utilization of various batteries.

In the case of secondary batteries, efficiency is becoming increasingly important depending on the application field, but problems such as heat generation and fires during charging or operation occur due to the external factors.

Accordingly, technologies are being developed to increase the operating efficiency of secondary batteries and ensure safety. Moreover, a recent surge in electricity usage has led to increased carbon emissions and exacerbated global warming concerns, which has called for more efficient device operation mechanisms, and improved cooling methods and maximization of cooling efficiency therefor.

### Related Art

(Patent Document 1) Korean Patent No. 10-2560884

### SUMMARY

According to an aspect of the present disclosure, provided is an immersion cooling module that can enhance the cooling efficiency for a battery module by cooling the battery module by immersion cooling and utilizing latent heat in a phase change of a cooling fluid during the immersion cooling process.

In addition, by effectively arranging and combining individual housings for immersion cooling of a battery module, the cooling efficiency of the entire cooling fluid can be improved, and the cooling effect for a battery module housed in each of the housings can also be maximized.

In order to achieve the above objectives, according to a general aspect of the present disclosure, there is provided an immersion cooling module including: a housing configured to contain a cooling fluid at a predetermined level; at least one unit housing accommodated inside the housing so as to be impregnated with the cooling fluid, configured to have a flow passage through which the cooling fluid flows in and out and an open top, and configured to accommodate a battery module therein; and at least one condenser coupled to liquefy a gas formed by vaporization of the cooling fluid in the housing and reintroduce the liquefied gas into the housing in a liquid state, wherein opposite sides of the battery module may be spaced apart from respective facing inner sides of the unit housing by a predetermined distance to form a flow path for the cooling fluid, and a porous moisture absorption member attached to each of the opposite sides of the battery module may be further included.

In this case, the battery module may comprise a plurality of battery cells that are arranged to be vertically stacked, and the porous moisture absorption member may be arranged to surround stacked surfaces of the battery cells and opposite sides of the battery cells in a stacked direction, optionally excluding a topmost surface of the battery module.

In addition, the flow passage of the unit housing may be formed in opposite directions of a lowermost battery cell among the battery cells of the battery module accommodated inside the unit housing.

In addition, the at least one condenser may be coupled inside the housing, but be provided above the unit housing, so that a gas may flow in toward an upper direction of the flow path at opposite ends of the unit housing, and the liquefied fluid may be reintroduced from above the battery module of the unit housing.

According to another embodiment of the present disclosure, there is provided an immersion cooling module including: a housing configured to contain a cooling fluid at a predetermined level; an inner housing impregnated with the cooling fluid, provided spaced apart from a lower surface of the housing, and in which a plurality of battery modules is accommodated spaced apart from each other; and at least one condenser coupled to liquefy a gas formed by vaporization of the cooling fluid in the housing and reintroduce the liquefied gas into the housing in a liquid state, wherein at least one flow passage through which the cooling fluid flows in and out may be provided on a lower surface of the inner housing in the separation space between the battery modules, and a porous moisture absorption member attached to facing sides of the battery modules that form the separation space where the flow passage is provided may be further included.

In this case, the inner housing may have a narrower width than the housing.

According to still another embodiment of the present disclosure, there is provided an immersion cooling module including: a housing configured to contain a cooling fluid at a predetermined level; a first housing configured to have a narrower width than the housing so as to be impregnated with the cooling fluid, and to have an open top to accommodate a first battery module inside; a second housing provided on the first battery module, accommodated inside the first housing, configured to have a narrower width than the first housing so as to be impregnated with the cooling fluid, and configured to have an open top to accommodate a second battery module inside; a third housing provided on the second battery module, accommodated inside the second housing, configured to have a narrower width than the second housing so as to be impregnated with the cooling fluid, and configured to have an open top to accommodate a third battery module inside; an inlet pipe through which the cooling fluid flows into the housing; a first inlet pipe provided in the first housing so that the cooling fluid flows into the first housing in an inflow direction of the cooling fluid flowing in through the inlet pipe; a second inlet pipe provided so that the cooling fluid flowing between the housing and the first housing in the inflow direction of the cooling fluid of the inlet pipe flows directly to the second housing; a third inlet pipe provided so that the cooling fluid flowing between the housing and the first housing in the inflow direction of the cooling fluid of the inlet pipe flows directly to the third housing; and at least one condenser combined to liquefy a gas resulting from the cooling fluid inside the first housing, the second housing and the third housing being vaporized and flowing upward and to reintroduce the liquefied gas into the housing in a liquid state.

In this case, the module may further include: an outlet pipe provided in an opposite direction of the inlet pipe so that the cooling fluid of the housing flows out; a first outlet pipe provided to communicate from the first housing to the housing in an outflow direction of the cooling fluid of the outlet pipe; a second outlet pipe provided to communicate from the second housing to the first housing in the outflow direction of the cooling fluid of the outlet pipe; and a third outlet pipe provided to communicate from the third housing to the second housing in the outflow direction of the cooling fluid of the outlet pipe.

In addition, the first, second, and third battery modules may be formed by stacking a plurality of battery cells vertically, and the porous moisture absorption member may be combined to surround stacked surfaces of the battery cells and opposite sides of the battery cells in a stacked direction.

According to another general aspect of the present disclosure, a method for cooling one or more battery modules comprises the following steps: providing the one or more battery modules inside at least one inner housing configured to respectively receive the one or more battery modules and arranged to be disposed inside a housing, the housing being configured to contain a cooling fluid, wherein the cooling fluid is introduced into at least one inner housing through a first inlet pipe, optionally further through a second inlet pipe and optionally further through a third inlet pipe; or is introduced into at least one inner housing through a flow passage. Furthermore, a state of the cooling fluid is changed via a phase change process from a liquid state to a vaporized gaseous state when the cooling fluid absorbs heat, so that the cooling fluid undergoes a phase transition into the vaporized gaseous state inside the at least one inner housing.

In an embodiment, opposite sides of each of the one or more battery modules may be spaced apart from respective facing inner sides of each of the at least one inner housing, and/or at least one condenser may be arranged to liquefy a gas formed by vaporization of the cooling fluid and reintroduce the liquefied gas into the housing in the liquid state, and the at least one condenser may be arranged to be disposed inside the housing above the at least one inner housing so that the gas can flow in toward an upper direction of the flow path at opposite ends of the at least one inner housing and the liquefied fluid can be reintroduced from above the one or more battery modules of the at least one inner housing, or the at least one condenser may be arranged to be disposed outside the housing so that the liquefied cooling fluid can be recirculated inside the housing.

In a further embodiment, the cooling fluid may be respectively introduced into the at least one inner housing from a bottom thereof, and/or a flow passage may be formed in opposite directions of a lowermost battery cell of each of the one or more battery modules respectively housed inside the at least one inner housing.

In a further embodiment, the cooling fluid may be allowed to flow and circulate in the flow path between the inner surface of the at least one inner housing and a porous moisture absorption member on one side of the one or more battery modules respectively facing the inner surface of the at least one inner housing.

In a further embodiment, the cooling fluid may be simultaneously introduced at multiple locations of each of the at least one inner housing, and/or the at least one inner housing may be arranged to be spaced apart from the lower surface of the housing, so that the cooling fluid can flow through the spaces of the side surface and the lower surface of each of the at least one inner housing.

In a further embodiment, a plurality of battery modules may be arranged to be vertically stacked in multiple stages inside the housing, in which a first inner housing and at least a second inner housing are arranged to accommodate individual battery modules of the plurality of battery modules in a form in which the width becomes narrower as going toward the top of the stacked plurality of battery modules, the cooling fluid may flow into the first inner housing and the at least second inner housing in the same direction as an inflow direction of the cooling fluid flowing through an inlet pipe of the housing, and the cooling fluid of the first inner housing and the at least second inner housing may be discharged in the same direction as an outflow direction to an outlet pipe on the opposite side of the inlet pipe of the housing.

In another aspect, in the module, or in the method described herein, the one or more battery modules may be replaced by at least one data center, server, and/or computing system.

The features and advantages of the present disclosure will become more apparent from the following detailed description based on the accompanying drawings.

Prior to this, terms or words used in this specification and claims should not be construed in their usual, dictionary meaning, and should be interpreted with meaning and concept consistent with the technical idea of the present disclosure on the basis of the principle that the inventor can define terminology appropriately to explain his or her invention in the best way possible.

According to an embodiment of the present disclosure, it is possible to enhance the cooling efficiency for a battery module immersed in a cooling fluid, thereby improving the reliability of operation of the entire device including the battery module.

Furthermore, in addition to cooling when the cooling fluid in each battery module circulates in a liquid state during immersion of battery modules, the cooling effect can be effectively induced by latent heat absorption during a phase change of the cooling fluid.

Furthermore, by improving the efficiency and reliability of the immersion cooling of a battery module, the power consumption of the entire device can be effectively reduced, thereby reducing carbon emissions.

Furthermore, by applying housings of different widths to individual battery modules housed within the housings, the independent operational reliability of the battery modules is maintained, improving the operational reliability of the entire device and maximizing the lifespan of the device, thereby reducing waste and mitigating environmental issues.

Furthermore, by applying housings and suitable replacements or modifications, it is possible that the one or more battery modules in the above modules and the above methods may be replaced by at least one data center, server, and/or computing system.

### BRIEF DESCRIPTION OF THE DRAWINGS

The above and other objectives, features, and other advantages of the present disclosure will be more clearly understood from the following detailed description when taken in conjunction with the accompanying drawings, in which:
FIG. 1 is a schematic view of an immersion cooling module according to an embodiment of the present disclosure;
FIG. 2 is a modified schematic view of an immersion cooling module according to an embodiment of the present disclosure;
FIG. 3 is a schematic view of an immersion cooling module according to another embodiment of the present disclosure;
FIG. 4 is a schematic view of an immersion cooling module according to still another embodiment of the present disclosure; and
FIG. 5 is a partial schematic plan view of an immersion cooling module according to FIG. 4.

### DETAILED DESCRIPTION

Terms used to describe an embodiment of the present disclosure are not intended to limit the disclosure. It should be noted that singular expressions include plural expressions unless the context clearly dictates otherwise.

It should be noted that, in assigning reference numerals to components in the drawings, identical components are assigned the same reference numerals as much as possible even if they are shown in different drawings, and similar reference numbers are assigned to similar components.

The drawings may be schematic or exaggerated for the purpose of illustrating the embodiments. In this document, expressions such as "have", "may have", "include", or "may include" refer to the presence of the corresponding feature (e.g., a numerical value, function, operation, or component such as a part), and do not exclude the presence of additional features.

Terms such as "one", "other", "another", "first", "second", etc., are used to distinguish one component from another component, and the components are not limited by the terms.

Hereinafter, an embodiment of the present disclosure will be described in detail with reference to the attached drawings.

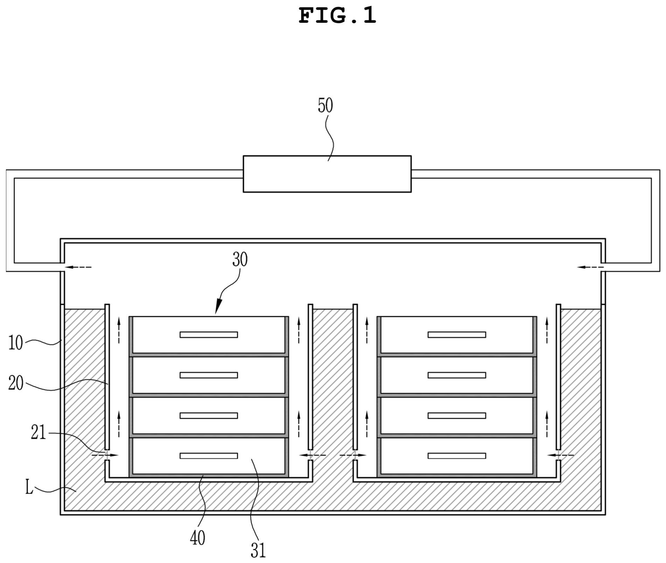

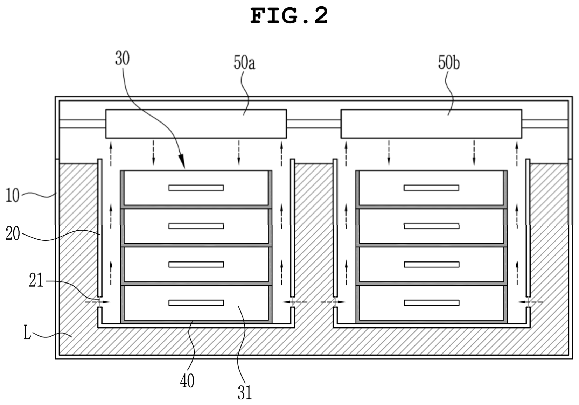

FIG. 1 is a schematic view of an immersion cooling module according to an embodiment of the present disclosure, and FIG. 2 is a modified schematic view of an immersion cooling module according to an embodiment of the present disclosure.

An immersion cooling module according to an embodiment of the present disclosure includes: a housing 10 containing a cooling fluid L at a predetermined level; at least one unit housing 20 that is accommodated inside the housing 10 so as to be impregnated with the cooling fluid L and has a flow passage 21 formed through which the cooling fluid L flows in and out, and configured to have an open top and accommodate a battery module 30 therein; and a condenser 50 coupled to liquefy a gas formed by vaporization of the cooling fluid L in the housing 10 and reintroduce the liquefied gas into the housing 10 in a liquid state. Opposite sides of the battery module 30 are spaced apart from the respective facing inner sides of the unit housing 20 by a predetermined distance to form a flow path for the cooling fluid L, and the module may further include a porous moisture absorption member 40 attached to each of the opposite sides of the battery module 30.

As shown in FIG. 1, the cooling fluid L is accommodated inside the housing 10. The cooling fluid L is provided at a predetermined level inside the housing 10, and a predetermined space may be formed so that a gas may be filled at a predetermined height above.

The unit housing 20 may be arranged to be impregnated with the cooling fluid L of the housing 10. The unit housing 20 may be formed to accommodate the battery module 30 therein while being impregnated with the cooling fluid L within the housing 10, so that the cooling fluid flows in and the battery module 30 is impregnated.

To be specific, as shown in FIG. 1, the unit housing 20 may be arranged to be impregnated with the cooling fluid L inside the housing 10, and the battery module 30 may be accommodated inside the unit housing 20. The unit housing 20 may refer to an inner housing that accommodates one or more battery modules 30.

The unit housing 20 may form the flow passage 21 so that the cooling fluid L inside the housing 10 may flow freely, and the flow passage 21 may be formed on each end of the lower part of the unit housing 20. As the battery module 30 is accommodated inside the unit housing 20 and the flow passage is formed in the unit housing 20 between the opposite sides of the battery module 30 and the inner side of the unit housing 20, the cooling fluid L is introduced into the unit housing 20 from the bottom thereof to effectively cool the battery module 30.

The flow passage 21 may be formed in opposite directions of the lowermost battery cell 31 of the battery module 30 housed inside the unit housing 20. Due to this, a flow path is formed between the inner surface of the unit housing 20 and one side of the battery module 30 facing the corresponding inner surface of the unit housing 20 and the flow direction of the cooling fluid L is directed upward, and heat absorption of the cooling fluid L that cools the battery module 30 increases as it goes upward, so that the cooling of the battery module may be performed through secondary phase change.

In the flow path between the inner surface of the unit housing 20 and one side of the battery module 30 through which the cooling fluid L flows, the porous moisture absorption member 40 may be attached to the side of the battery module 30 facing the inner surface of the unit housing 20, that is, the side of the battery module 30 in contact with the flow path. By combining the porous moisture absorption member 40 to each of the stacking surfaces on which the battery cells 31 are stacked, the cooling fluid L flows into and is impregnated into the porous moisture absorption member 40, thereby effectively performing cooling on each stacking surface of the battery cells 31.

Although in an embodiment of the present disclosure, the battery cells 31 of the battery module 30 are shown in a structure in which the battery cells 31 are stacked vertically, but the stacking direction and shape may be appropriately changed as needed. However, even in this case, the formation of a flow path through which the cooling fluid L can flow upwards inside the unit housing 20 and the attachment of the porous moisture absorption member 40 to one side of the battery module 30 in contact with the flow path should be applied equally.

By doing so, the action of vaporizing the cooling fluid L flowing upward and supplying gas to the internal space of the housing 10 may occur more effectively.

In addition, the battery module 30 may be cooled by allowing the cooling fluid L to flow and circulate in the flow path between the inner surface of the unit housing 20 and the porous moisture absorption member 40 on one side of the battery module 30 facing the inner surface of the unit housing 20, and due to heat generation at the coupling surface of the battery module 30, the cooling fluid L absorbed by the porous moisture absorption member 40 may cool the battery module 30 using the latent heat in the phase change process in which the cooling fluid L absorbs heat, causing the cooling fluid L to change state.

In this way, the vaporized gas resulting from the phase change of the cooling fluid L may naturally rise to the upper part of the flow path inside the unit housing 20 and fill a predetermined space inside the housing 10.

As shown in FIG. 1, by discharging the gas filled in the predetermined space at the upper part of the housing 10 toward one side of the space of the housing 10 and liquefying the gas by means of a condenser 50, the liquefied cooling fluid L may be reintroduced toward the other side of the space inside the housing 10. In this case, by combining the condenser 50 outside the housing 10 and reintroducing and circulating the liquefied cooling fluid L inside the housing 10, the effective circulation and cooling efficiency of the cooling fluid L inside the housing 10 may be enhanced.

The condenser 50 may receive the gas through a hollow pipe connected from the space inside the housing 10 and reintroduce the liquefied cooling fluid L into the other side of the space inside the housing 10 through a hollow pipe, which is the hollow pipe connected through the condenser 50. The passage for the movement of the gas may be a conduit such as a hollow pipe, and a heat exchanger or circulation device for other functions may be additionally connected and combined.

As shown in FIG. 2, the condenser 50 may be coupled inside the housing 10 but provided above the unit housing 20, so that the vaporized gas may flow into the condenser 50 through the upper part of the flow path formed at opposite ends of the unit housing 20, and the liquefied cooling fluid L at the upper part of the battery module 30 of the unit housing 20 may be reintroduced by the condenser 50.

That is, in this case, the condenser 50 (50a and 50b) is directly coupled above the unit housing 20 in the internal space of the housing 10, so that the cooling fluid L is vaporized through the flow path formed on each side of the unit housing 20, and the vaporized gas may be directly introduced into the condensers 50a and 50b. The condensers 50a and 50b liquefy the introduced gas, thereby re-introducing the liquefied cooling fluid L toward the battery module 30, thereby cooling the battery module 30.

As shown in FIG. 2, in the case that there are multiple unit housings 20 inside the housing 10, the condensers 50a and 50b may be respectively connected to the unit housings 20.

In addition, the design may be changed by combining the condensers 50a and 50b used in combination with or integrated into the combined structure of the condenser 50 connected to the outside of the housing 10 already described above.

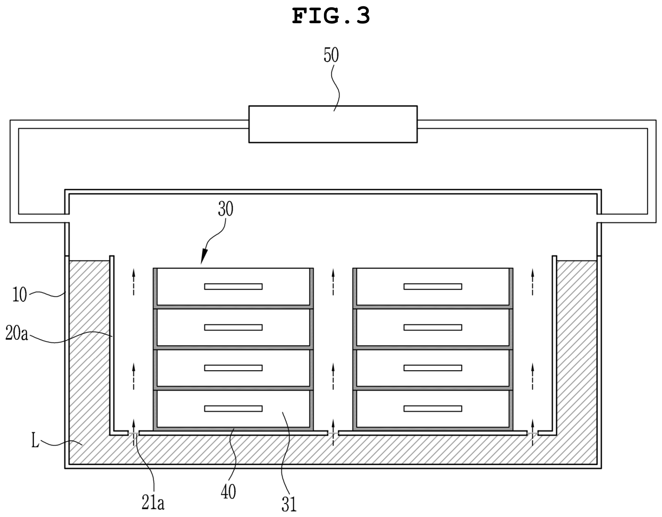

FIG. 3 is a schematic view of an immersion cooling module according to another embodiment of the present disclosure.

The immersion cooling module according to another embodiment of the present disclosure may include: a housing 10 containing a cooling fluid L at a predetermined level; an inner housing 20a provided spaced apart from the lower surface of the housing 10 so as to be impregnated with the cooling fluid L, in which a plurality of battery modules 30 are accommodated spaced apart from each other, and whose top is open; and a condenser 50 coupled to liquefy a gas formed by vaporization of the cooling fluid L in the housing 10 and reintroduce the liquefied gas into the housing 10 in a liquid state. At least one flow passage 21a through which the cooling fluid L flows in and out is formed on the lower surface of the inner housing 20a in the separation space between the battery modules 30, and the module may further include a porous moisture absorption member 40 attached to facing sides of the battery modules 30 in the separation space where the flow passage 21a is formed.

As shown in FIG. 3, in the immersion cooling module according to another embodiment of the present disclosure, the inner housing 20a with an open top may be installed separately inside the housing 10 in which the cooling fluid L is contained at a predetermined level.

It is appropriate that the inner housing 20a is configured and arranged with a narrower width than the housing 10 inside the housing 10, so that a separation space between the housing 10 and the inner housing 20a is formed. In addition, the inner housing 20a is provided to be spaced apart from the lower surface of the housing 10 so that the cooling fluid L may flow through the spaces of the side surface and the lower surface of the inner housing 20a.

At least one inner housing 20a may be provided, and at least one battery module 30 may be placed inside the inner housing 20a. A flow passage 21a may be formed so that the cooling fluid L can flow into the inner housing 20a.

The flow passage 21a may be formed on the lower surface of the inner housing 20a to allow the cooling fluid L to flow in. In the case that multiple battery modules 30 are arranged inside the inner housing 20a, the flow passage 21a may be formed on the lower surface of the inner housing 20a corresponding to the separation space between the battery modules 30.

Since the cooling fluid L is introduced at once through the flow passage 21a at each location of the inner housing 20a, the cooling temperature of the cooling fluid introduced into individual battery module 30 placed inside the inner housing 20a is uniform, so that effective cooling may be performed.

The cooling fluid L is simultaneously introduced at multiple locations of the inner housing 20a, so that the temperature deviation of the cooling fluid L flowing inside the inner housing 20a is small, and thus the cooling efficiency and balance between the battery modules 30 may be effectively maintained.

The flow passage 21a may be formed in the space between the battery modules 30 of the inner housing 20a, and the number and the diameter or area of the flow passage 21a may be appropriately selected and applied in consideration of the cooling efficiency and the range to be cooled, such as the size of the inner housing 20a or the number of battery modules 30.

As already described above, the porous moisture absorption member 40 may be attached to the side of the battery module 30 placed inside the inner housing 20a so as to be in contact with the direction in which the cooling fluid L flows. In this way, the cooling fluid L is absorbed and remains in the porous moisture absorption member 40 coupled to the side of the battery module 30, thereby cooling the battery module 30, and in the cooling process, as the cooling fluid L naturally undergoes a phase change by absorbing heat through latent heat, the battery module 30 may be cooled.

Through this process, the vaporized cooling fluid L from the inner housing 20a fills the internal space of the housing 10, and the gas in the internal space of the housing 10 is circulated by means of the condenser 50 and reintroduced into the housing 10 as the liquefied cooling fluid L, thereby effectively circulating the cooling fluid L.

The technical configuration of another embodiment identical or corresponding to the immersion cooling module according to an embodiment of the present disclosure is substantially the same, and thus overlapping descriptions thereof will be omitted.

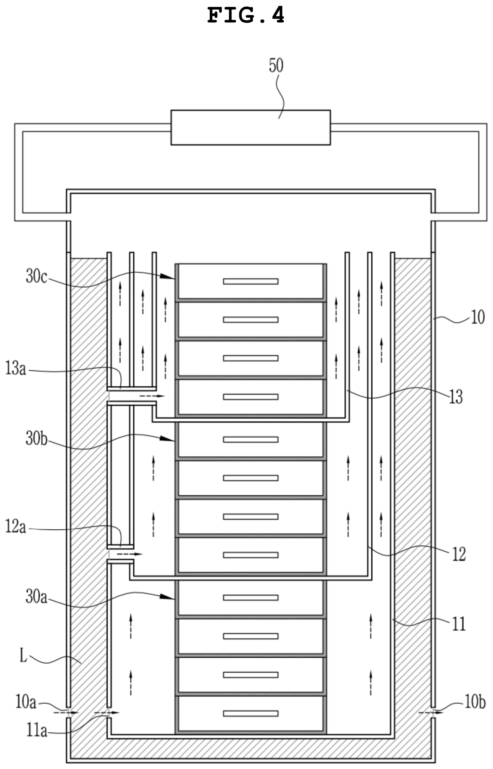

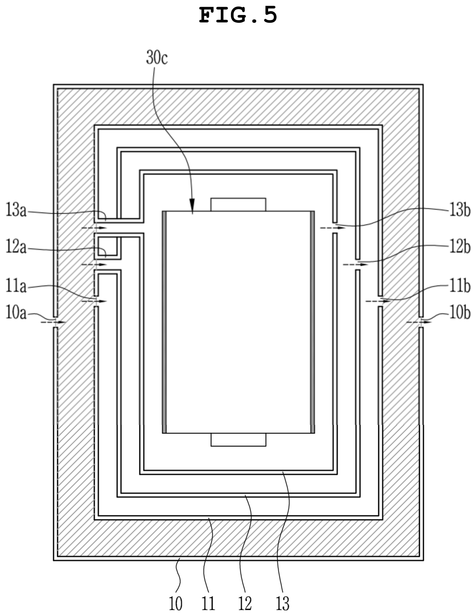

FIG. 4 is a schematic view of an immersion cooling module according to still another embodiment of the present disclosure, and FIG. 5 is a partial schematic plan view of an immersion cooling module according to FIG. 4.

The immersion cooling module according to still another embodiment of the present disclosure may include: a housing 10 containing a cooling fluid L at a predetermined level; a first housing 11 impregnated with the cooling fluid L, having a narrower width than the housing 10, and having an open top to accommodate a first battery module 30a inside; a second housing 12 provided on the first battery module 30a, accommodated inside the first housing 11, impregnated with the cooling fluid L, having a narrower width than the first housing 11, and having an open top to accommodate a second battery module 30b inside; a third housing 13 provided on the second battery module 30b, accommodated inside the second housing 12, impregnated with the cooling fluid L, having a narrower width than the second housing 12, and having an open top to accommodate a third battery module 30c inside; an inlet pipe 10a through which cooling fluid flows into the housing 10; a first inlet pipe 11a provided in the first housing 11 so that the cooling fluid L flows into the first housing 11 in the inflow direction of the cooling fluid L flowing in through the inlet pipe 10a; a second inlet pipe 12a provided so that the cooling fluid L flowing between the housing 10 and the first housing 11 in the inflow direction of the cooling fluid L of the inlet pipe 10a flows directly to the second housing 12; a third inlet pipe 13a provided so that the cooling fluid L flowing between the housing 10 and the first housing 11 in the inflow direction of the cooling fluid L of the inlet pipe 10a flows directly to the third housing 13; and a condenser 50 configured to liquefy the gas resulting from the cooling fluid L inside the first housing 11, the second housing 12 and the third housing 13 being vaporized and flowing upward and to reintroduce the liquefied gas into the housing 10 in a liquid state.

As shown in FIG. 4, in the immersion cooling module according to still another embodiment of the present disclosure, a plurality of battery modules 30 is stacked vertically in multiple stages inside the housing 10, and the first housing 11, the second housing 12, and the third housing 13 that accommodate individual battery module 30 may be arranged in a form in which the width becomes narrower as going toward the top of the stacked battery modules 30.

The first housing 11, the second housing 12, and the third housing 13 may also respectively be referred to as first inner housing 11, second inner housing 12, and third inner housing 13 that are each being disposed inside the housing 10, and may preferably be vertically stacked.

The cooling fluid L may flow into the first housing 11, the second housing 12, and the third housing 13 in the same direction as the inflow direction of the cooling fluid L flowing through the inlet pipe 10a of the housing 10, and the cooling fluid L inside the first housing 11, the second housing 12, and the third housing 13 may be discharged in the same direction as the outflow direction to an outlet pipe 10b on the opposite side of the inlet pipe 10a of the housing 10.

To be specific, as shown in FIG. 4, the first housing 11 that has a narrower width than the housing 10 and has an open top may be provided inside the housing 10 containing the cooling fluid L of a predetermined level so as to be impregnated with the cooling fluid L. The first battery module 30a is provided inside the first housing 11, and the cooling fluid L is introduced into the first inlet pipe 11a of the first housing 11 to cool the first battery module 30a. The first inlet pipe 11a may be formed so that the cooling fluid is naturally introduced in the flow direction of the cooling fluid L flowing from the inlet pipe 10a of the housing 10. That is, the first inlet pipe 11a may be formed in the first housing 11 in the same direction as one side of the housing 10 in which the inlet pipe 10a is formed.

The second housing 12 that is narrower than the first housing 11 and has an open top is accommodated in the direction in which the first housing 11 is opened on the top of the first battery module 30a inside the first housing 11, and the second battery module 30b is accommodated inside the second housing 12. The second housing 12 may have the second inlet pipe 12a formed therein to allow the cooling fluid L to flow into the interior of the second housing 12. In this case, the cooling fluid L flowing into the second inlet pipe 12a is not the cooling fluid L flowing into the first housing 11 and cooling the first battery module 30a but the cooling fluid L inside the housing 10 that has not flowed into the first housing 11 flows directly into the second housing 12. To this end, the second inlet pipe 12a may be formed such that the cooling fluid L of the housing 10 flows directly into the second housing 12 without passing through the inside of the first housing 11. For example, the second inlet pipe 12a may be formed in a physical shape of a pipe so that the inside of the housing 10 and the inside of the second housing 12 are directly connected to guide the flow of the cooling fluid.

The third housing 13 is placed on top of the second battery module 30b, and may be formed to have a narrower width than the second housing 12 and an open top to accommodate the third battery module 30c inside.

The third inlet pipe 13a may be formed to allow the cooling fluid L to flow into the third housing 13. In this case, instead of the cooling fluid L flowing into the second housing 12 and cooling the second battery module 30b, the cooling fluid L inside the housing 10 that has not flowed into the first housing 11 and the second housing 12 may flow directly into the third housing 13.

To this end, the third inlet pipe 13a may be formed such that the cooling fluid L of the housing 10 flows directly into the third housing 13 without passing through the inside of the second housing 12. For example, the third inlet pipe 13a may be formed in a physical shape of a pipe so that the inside of the housing 10 and the inside of the third housing 13 are directly connected to guide the flow of the cooling fluid

By doing so, the cooling fluid L flowing into the first housing 11, the second housing 12, and the third housing 13 may flow at the cooling temperature of the initial cooling fluid L flowing into the housing 10.

In addition, as shown in FIG. 5, by arranging the first inlet pipe 11a, the second inlet pipe 12a, and the third inlet pipe 13a in the same direction as the flow direction of the cooling fluid L flowing into the inlet pipe 10a of the housing 10, the cooling fluid L may be naturally introduced into each of the inlet pipes 11a, 12a and 13a.

When introducing cooling fluid L into the inlet pipe 10a of the housing 10, if a separate driving force is used, the fluid introduced into the housing 10 is subjected to external pressure in the direction of the first housing 11, the second housing 12, and the third housing 13, thereby naturally introducing the cooling fluid L into the interior of each housing.

The housing 10 may have the outlet pipe 10b on the opposite side of the inlet pipe 10a so that the cooling fluid L inside the housing 10 may flow out.

A first outlet pipe 11b may be formed so that the internal fluid of the first housing 11 flows out from the first housing 11 to the housing 10, so that the cooling fluid L flows out in the direction of the outlet of the housing 10.

As shown in FIG. 5, second outlet pipe 12b may be formed to allow the cooling fluid L inside the second housing 12 to flow out toward the first housing 11, and a third outlet pipe 13b may be formed to allow the cooling fluid L inside the third housing 13 to flow out toward the second housing 12.

That is, the cooling fluid L may be sequentially discharged from the third housing 13 into the space of the second housing 12, then into the space of the first housing 11, and then into the space of the housing 10. By allowing the cooling fluid L to flow through each housing 10 step by step and finally to the outlet pipe 10b of the housing 10, the temperature difference of the entire cooling fluid L inside the housing 10 may be reduced.

As shown in FIGS. 4 and 5, the first housing 11 accommodates the cooling fluid L with a relatively largest capacity, and then the accommodation space is reduced as going to the second housing 12 and the third housing 13. Therefore, when the cooling fluid L is discharged, as the cooling fluid L passes through the second housing 12 and the first housing 11 from the third housing 13, which is the space where the temperature of the cooling fluid L rises the most, the cooling fluid fractions L1, L2, L3 from the first, second, third housings, respectively, are mixed with each other, alleviating the decrease in cooling temperature, thereby maintaining the balance of the cooling temperature of the cooling fluid L inside the housing 10, and thus maintaining a stable cooling efficiency overall.

Since the description of the first battery module 30a, the second battery module 30b, and the third battery module 30c is substantially the same as that of the battery module 30 described above, the description of the redundant description related to the porous moisture absorption member 40 combined with the battery module 30 and the stacked structure will be omitted.

At least one or all of the battery modules 30, 30a, 30b, 30c described above may be replaced by at least one data center(s), server(s), and/or high-performance computing system(s), for cooling purposes.

Above, the present disclosure has been described in detail through specific embodiments. The embodiments are for specifically explaining the present disclosure, and are only illustrative and do not limit the scope of the appended claims. It is obvious to those skilled in the art that various changes and modifications to the embodiments are possible within the scope and technical idea of the present disclosure, and it is natural that such changes and modifications fall within the scope of the appended claims.

## Claims

1. An immersion cooling module comprising:
a housing (10) configured to contain a cooling fluid (L);
at least one unit housing (20) accommodated inside the housing so as to be impregnated with the cooling fluid, configured to have a flow passage (21) through which the cooling fluid (L) flows in and out and an open top, and configured to accommodate a battery module (30) therein; and
at least one condenser (50, 50a, 50b) coupled to liquefy a gas formed by vaporization of the cooling fluid (L) in the housing (10) and reintroduce the liquefied gas into the housing (10) in a liquid state,
wherein opposite sides of the battery module (30) are spaced apart from respective facing inner sides of the unit housing (20) by a predetermined distance to form a flow path for the cooling fluid (L), and a porous moisture absorption member (40) attached to each of the opposite sides of the battery module (30) is further included.

2. The module of claim 1, wherein the battery module (30) comprises a plurality of battery cells (31) that are arranged to be vertically stacked, and the porous moisture absorption member (40) is arranged to surround stacked surfaces of the battery cells (31) and opposite sides of the battery cells (31) in a stacked direction, optionally excluding the topmost surface of the battery module (30).

3. The module of claim 1 or 2, wherein the flow passage (21) of the unit housing (20) is formed in opposite directions of a lowermost battery cell among the battery cells (31) of the battery module (30) accommodated inside the unit housing (20).

4. The module of any one of claims 1 to 3, wherein the at least one condenser (50, 50a, 50b) is coupled inside the housing (10), but is provided above the unit housing (20), so that a gas flows in toward an upper direction of the flow path at opposite ends of the unit housing (20), and the liquefied fluid is reintroduced from above the battery module (30) of the unit housing (20).

5. An immersion cooling module comprising:
a housing (10) configured to contain a cooling fluid (L) ;
an inner housing (20a) impregnated with the cooling fluid (L), provided spaced apart from a lower surface of the housing (10), and in which a plurality of battery modules (30) is accommodated spaced apart from each other; and
at least one condenser (50) coupled to liquefy a gas formed by vaporization of the cooling fluid (L) in the housing (10) and reintroduce the liquefied gas into the housing (10) in a liquid state,
wherein at least one flow passage (21a) through which the cooling fluid (L) flows in and out is provided on a lower surface of the inner housing (20a) in the separation space between the battery modules (30), and a porous moisture absorption member (40) attached to facing sides of the battery modules (30) that form the separation space where the flow passage (21a) is provided is further included

6. The module of claim 5, wherein the inner housing (20a) has a narrower width than the housing (10).

7. An immersion cooling module comprising:
a housing (10) configured to contain a cooling fluid (L);
a first housing (11) configured to have a narrower width than the housing (10) so as to be impregnated with the cooling fluid (L), and to have an open top to accommodate a first battery module (30a) inside;
a second housing (12) provided on the first battery module (30a), accommodated inside the first housing (11), configured to have a narrower width than the first housing (11) so as to be impregnated with the cooling fluid (L), and configured to have an open top to accommodate a second battery module (30b) inside;
a third housing (13) provided on the second battery module (30b), accommodated inside the second housing (12), configured to have a narrower width than the second housing (12) so as to be impregnated with the cooling fluid (L), and configured to have an open top to accommodate a third battery module (30c) inside;
an inlet pipe (10a) through which the cooling fluid (L) flows into the housing (10);
a first inlet pipe (11a) provided in the first housing (11) so that the cooling fluid (L) flows into the first housing (11) in an inflow direction of the cooling fluid (L) flowing in through the inlet pipe (10a);
a second inlet pipe (12a) provided so that the cooling fluid (L) flowing between the housing (10) and the first housing (11) in the inflow direction of the cooling fluid (L) of the inlet pipe (10a) flows directly to the second housing (12);
a third inlet pipe (13a) provided so that the cooling fluid (L) flowing between the housing (10) and the first housing (11) in the inflow direction of the cooling fluid (L) of the inlet pipe (10a) flows directly to the third housing (13); and
at least one condenser (50) combined to liquefy a gas resulting from the cooling fluid (L) inside the first housing (11), the second housing (12) and the third housing (13) being vaporized and flowing upward and to reintroduce the liquefied gas into the housing (10) in a liquid state.

8. The module of claim 7, further comprising:
an outlet pipe (10b) provided in an opposite direction of the inlet pipe (10a) so that the cooling fluid (L) of the housing (10) flows out;
a first outlet pipe (11b) provided to communicate from the first housing (11) to the housing (10) in an outflow direction of the cooling fluid (L) of the outlet pipe (10b);
a second outlet pipe (12b) provided to communicate from the second housing (12) to the first housing (11) in the outflow direction of the cooling fluid (L) of the outlet pipe (10b); and
a third outlet pipe (13b) provided to communicate from the third housing (13) to the second housing (12) in the outflow direction of the cooling fluid (L) of the outlet pipe (10b).

9. The module of claim 7 or 8, wherein the first, second, and third battery modules (30a, 30b, 30c) are formed by stacking a plurality of battery cells (31) vertically, and the porous moisture absorption member (40) is combined to surround stacked surfaces of the battery cells (31) and opposite sides of the battery cells (31) in a stacked direction.

10. A method for cooling one or more battery modules (30, 30a), comprising:
providing the one or more battery modules (30, 30a) inside at least one inner housing (20, 20a) configured to respectively receive the one or more battery modules (30, 30a) and arranged to be disposed inside a housing (10), the housing (10) being configured to contain a cooling fluid (L),
wherein the cooling fluid (L) is introduced into at least one inner housing (20, 20a) through a first inlet pipe (11a), optionally further through a second inlet pipe (12a) and optionally further through a third inlet pipe (13a),
or is introduced into at least one inner housing (20, 20a) through a flow passage (21, 21a); and
wherein a state of the cooling fluid L is changed via a phase change process from a liquid state to a vaporized gaseous state when the cooling fluid (L) absorbs heat, so that the cooling fluid (L) undergoes a phase transition into the vaporized gaseous state inside the at least one inner housing (20, 20a).

11. The method of claim 10,
wherein opposite sides of each of the one or more battery modules (30, 30a) are spaced apart from respective facing inner sides of each of the at least one inner housing (20, 20a); and/or
wherein at least one condenser (50) is arranged to liquefy a gas formed by vaporization of the cooling fluid (L) and reintroduce the liquefied gas into the housing (10) in the liquid state, optionally wherein the at least one condenser (50a,50b) is arranged to be disposed inside the housing (10) above the at least one inner housing (20) so that the gas can flow in toward an upper direction of the flow path at opposite ends of the at least one inner housing (20) and the liquefied fluid can be reintroduced from above the one or more battery modules (30) of the at least one inner housing (20), or optionally wherein the at least one condenser (50) is arranged to be disposed outside the housing (10) so that the liquefied cooling fluid (L) can be recirculated inside the housing (10).

12. The method of claim 10 or 11,
wherein the cooling fluid (L) is respectively introduced into the at least one inner housing (20, 20a) from a bottom thereof, and/or
wherein a flow passage (21, 21a) is formed in opposite directions of a lowermost battery cell (31) of each of the one or more battery modules (30, 30a) respectively housed inside the at least one inner housing (20, 20a).

13. The method of any one of claims 10 to 12,
wherein the cooling fluid (L) is allowed to flow and circulate in the flow path between the inner surface of the at least one inner housing (20, 20a) and a porous moisture absorption member (40) on one side of the one or more battery modules (30, 30a) respectively facing the inner surface of the at least one inner housing (20, 20a).

14. The method of any one of claims 9 to 12,
wherein the cooling fluid (L) is simultaneously introduced at multiple locations of each of the at least one inner housing (20, 20a), and/or
wherein the at least one inner housing (20, 20a) is arranged to be spaced apart from the lower surface of the housing (10) so that the cooling fluid (L) can flow through the spaces of the side surface and the lower surface of each of the at least one inner housing (20, 20a).

15. The method of any one of claims 10 to 14,
wherein a plurality of battery modules (30, 30a) is arranged to be vertically stacked in multiple stages inside the housing (10), in which a first inner housing (11) and at least a second inner housing (12) are arranged to accommodate individual battery modules (30, 30a) of the plurality of battery modules (30, 30a) in a form in which the width becomes narrower as going toward the top of the stacked plurality of battery modules (30, 30a),
wherein the cooling fluid (L) flows into the first inner housing (11) and the at least second inner housing (12) in the same direction as an inflow direction of the cooling fluid (L) flowing through an inlet pipe (10a) of the housing (10), and the cooling fluid (L) of the first inner housing (11) and the at least second inner housing (12) is discharged in the same direction as an outflow direction to an outlet pipe (10b) on the opposite side of the inlet pipe (10a) of the housing (10).
